# DEMANDE DE BREVET EUROPEEN

(11) **EP 1 351 314 A2**
(43) Date de publication de la demande: **08.10.2003**
(21) Numéro de dépôt: 03100394.0
(22) Date de dépôt: 20.02.2003
(51) Int. Cl.: H01L 29/92, H01L 21/02

(54) **Micro-composant électronique incorporant une structure capacitive, et procédé de réalisation**

(30) Priorité: 27.02.2002 FR 0202461
(71) Demandeur: Memscap, 38190 Bernin (FR)
(72) Inventeur: GIRARDIE, Lionel, 38320, EYBENS (FR)
(74) Mandataire: Palix, Stéphane

(57) **Abrégé**

Micro-composant électronique (1) réalisé à partir d'un substrat (2), et incorporant une structure capacitive réalisée au-dessus du dernier niveau de métallisation (3) apparent réalisé dans le substrat, ladite structure capacitive comportant deux électrodes (31,45), caractérisé en ce qu'une des électrodes (31) comporte un ensemble de lamelles (25,26) superposées et décalées de l'une à l'autre par rapport à un tronc central (27), l'autre électrode (45) comportant deux ensembles de lamelles (40,41), les lamelles (40,41) de chacun de ces ensembles étant intercalées entre les lamelles (25,26) de la première électrode (31) en étant reliées entre elles par une paroi commune (42,43), les deux parois commune (42,43) étant elles-mêmes reliées (44) par dessus la première électrode (31).

## Description

### Domaine technique

L'invention se rattache au domaine technique de la micro-électronique. Elle vise plus précisément des micro-composants électroniques incorporant une ou plusieurs structures capacitives formant des micro-condensateurs. Ces composants peuvent notamment être utilisés dans le cadre d'applications radiofréquence par exemple, et peuvent notamment servir de capacités de découplage.

L'invention vise plus précisément la structure d'une telle capacité en vue d'en augmenter très fortement sa "capacitance", c'est-à-dire sa capacité par unité de surface, et ce sans augmenter trop fortement les coûts de fabrication.

### Techniques antérieures

La réalisation de micro-condensateurs ou de structures capacitives sur des substrats semi-conducteurs a déjà fait l'objet de certains développements.

Différentes technologies ont déjà vu le jour, et notamment celles qui permettent de réaliser des structures capacitives constituées de deux électrodes formées par des couches métalliques, séparées par une couche de matériau isolant ou diélectrique. Ce type de capacités est généralement qualifié de structure "MIM" pour "Métal Isolant Métal". L'invention se rattache à ce type de structure capacitive.

Parmi les solutions existantes, celle décrite dans le document FR 2 801 425 concerne un micro-condensateur dont les deux électrodes sont formées par des couches métalliques planes. Dans ce cas, la valeur de la capacité du condensateur est essentiellement fonction du type de matériau diélectrique utilisé, ainsi que de la surface en regard des deux électrodes métalliques. Autrement dit, la "capacitance", ou la capacité par unité de surface, est fixée de façon prépondérante par l'épaisseur de la couche isolante et sa permittivité relative. Ainsi, pour augmenter la valeur de capacitance, il est nécessaire soit de choisir des matériaux de très forte permittivité relative, soit de réduire les distances entre les électrodes, avec le risque d'apparition de phénomènes de claquage voire d'effets tunnels. Autrement, les condensateurs réalisés selon la structure décrite dans ce document sont limités en terme de capacitance.

Le Déposant a décrit dans la demande de brevet français n° 02.01618, non encore publiée à la date de dépôt de la présente demande, une nouvelle structure de capacité réalisée sur un niveau de métallisation d'un composant électronique. Chaque électrode de cette structure capacitive comporte une pluralité de lamelles métalliques qui sont perpendiculaires au plan principal du substrat.

Une autre structure capacitive a été décrite dans le document US 5834 357. Cet type de structure comporte une pluralité de lamelles conductrices,; typiquement en dioxyde de ruthénium (RuO₂), empilées les unes au dessus des autres, et séparées par des zones réalisées en un matériau différent, et par exemple en ruthénium (Ru). Plus précisément, on réalise un empilement des couches alternées de RuO₂ et de Ru, puis on procède à une gravure des couches de Ru, de manière à ne conserver ces dernières qu'au niveau du tronc central. Ce type de structure capacitive présente donc l'inconvénient que les électrodes combinent des couches de matériaux différents, avec des incidences électriques, et des complications en termes de procédé de fabrication.

Un des objectifs de l'invention est de proposer une structure capacitive qui puisse être réalisée sur un dernier niveau de métallisation apparent d'un micro-composant électronique, qui soit aisée à réaliser, et qui possède une valeur de capacité par unité de surface qui soit nettement plus élevée que les valeurs habituellement observées.

### Exposé de l'invention

L'invention concerne donc un micro-composant électronique réalisé à partir d'un substrat semi-conducteur, et qui incorpore une structure capacitive réalisée au-dessus du dernier niveau de métallisation apparent du substrat. Cette structure capacitive comporte deux électrodes dont, conformément à l'invention :
■ une des électrodes comporte un ensemble de lamelles superposées parallèlement au plan du substrat, et décalée de l'une à l'autre par rapport à un tronc central ;
■ l'autre électrode comporte deux ensembles de lamelles, les lamelles de chaque ensemble étant intercalées entre les lamelles de la première électrode en étant reliées entre elles par une paroi commune, les deux parois communes étant elles-mêmes reliées par dessus la première électrode.

Autrement dit, la première électrode forme une structure arborescente dont le tronc est formée par la superposition des portions en recouvrement de chacune des lamelles. La seconde électrode recouvre la première en formant une pluralité de lamelles qui sont intercalées entre les lamelles de la première électrode situées de part et d'autre du tronc central. La surface en regard de chacune des électrodes est donc particulièrement élevée.

Pour une même surface occupée sur le substrat, cette surface en regard peut être accrue en augmentant le nombre de lamelles de chaque électrode, ce qui permet donc d'augmenter la capacitance à souhait.

En pratique, les électrodes sont séparées par une couche diélectrique réalisée à partir de matériaux qui sont avantageusement choisis dans le groupe des oxydes ferro-électriques et pyroélectriques. Parmi ces oxydes ferroélectriques, on connaît le dioxyde d'Hafnium, le pentoxyde de Tantale, le dioxyde de Zirconium, les oxydes de Lanthane, le trioxyde de di-Yttrium, l'alumine, le dioxyde de Titane, ainsi que les titanates et tantalates de Strontium (STO), les titanates de Strontium et Baryum (BST), les Tantalates de Strontium et Bismuth (SBT), ainsi que les titanates de Plomb et de zirconate de Plomb (PZT) , les titanates et zirconates de Plomb dopées avec des Lanthanides (PLZT), les nobiates de Strontium et Bismuth (SBN), les tantalates et niobates de Strontium et Bismuth (SBTN), les cuprates de Baryum et Yttrium, les Alcalinoxydes de Manganèse Me₂MnO₃

Ce matériau diélectrique peut être déposé soit en couche homogène d'un même matériau, ou d'un alliage de plusieurs de ces matériaux.

Néanmoins, dans une forme préférée, la couche diélectrique peut également être constituée de la superposition de couches élémentaires de matériaux différents formant une structure nanolaminée. Dans ce cas, chacune des couches est de très faible épaisseur, de l'ordre de quelques Angström à quelques centaines d'Angström.

Dans une forme préférée, la stoechiométrie des matériaux varie d'une couche élémentaire à l'autre dans la structure nanolaminée. Ainsi, en faisant varier la stoechiométrie de chaque couche, on crée des gradients de concentration d'oxygène (et des autres matériaux utilisés) à travers quelques couches atomiques. La variation de structure de bandes de chaque couche élémentaire de la structure nanolaminée a pour conséquence de modifier la structure de bande globale des alliages et des composés d'oxydes ferro et pyroélectriques à travers seulement quelques couches atomiques.

On obtient de la sorte des valeurs de permittivité relative particulièrement importantes, ce qui agit en faveur de l'augmentation de la capacitance.

En pratique, on préférera que la surface de chaque électrode soit recouverte d'une couche de matériau barrière à la diffusion de l'oxygène, typiquement à base de nitrure de titane, de nitrure de tungstène, de nitrure de tantale, ou bien encore l'un des matériaux suivants : TaA1N, TiA1N, MoN, CoW ou TaSiN.

Avantageusement, les différentes lamelles faisant partie de chacune des électrodes sont réalisées à partir du même matériau, ce qui améliore le comportement électrique du condensateur, en éliminant notamment certains risques de défectivité.

En pratique, le matériau utilisé pour former les électrodes peut être du tungstène, ou plus généralement tout matériau conducteur possédant une bonne conductivité électrique. Les électrodes peuvent ainsi être réalisées en cuivre, ce qui permet d'utiliser des méthodes de dépôt électrolytique.

L'invention concerne également un procédé de fabrication d'une telle structure capacitive. Cette structure capacitive est fabriquée sur un micro-composant, au-dessus du dernier niveau de métallisation apparent réalisé dans le substrat du micro-composant.

Conformément à l'invention, le procédé comporte les étapes suivantes consistant à :
■ déposer au-dessus du niveau de métallisation, une couche métallique destinée à former la partie basse d'une des deux électrodes de la structure capacitive ;
■ déposer au-dessus de la couche métallique une couche structurante de manière à définir un canal destiné à accueillir un dépôt métallique ;
■ déposer dans le canal ainsi formé un dépôt métallique ;
■ renouveler les deux étapes précédentes autant de fois que nécessaire, en fonction de la géométrie souhaitée de la capacité, en décalant d'une fois sur l'autre la position de la couche structurante pour ne couvrir qu'une partie de la couche métallique sous-jacente, de manière à également décaler les futurs dépôts métalliques, et obtenir ainsi une structure arborescente formant la première électrode ;
■ déposer au-dessus de la première électrode une couche de matériau diélectrique selon les compositions décrites ci-avant et notamment en ce qui concerne les structures nanolaminées ;
■ déposer par dessus la première électrode un matériau conducteur venant s'insérer entre les différentes couches métalliques de la première électrode.

### Description sommaire des figures

La manière de réaliser l'invention ainsi que les avantages qui en découlent ressortiront bien de la description du mode de réalisation qui suit, à l'appui des figures annexées numérotées 1 à 19, représentant une vue en coupe du micro-composant conforme à l'invention au niveau de la structure capacitive caractéristique, et ce au fur et à mesure des étapes de fabrication.

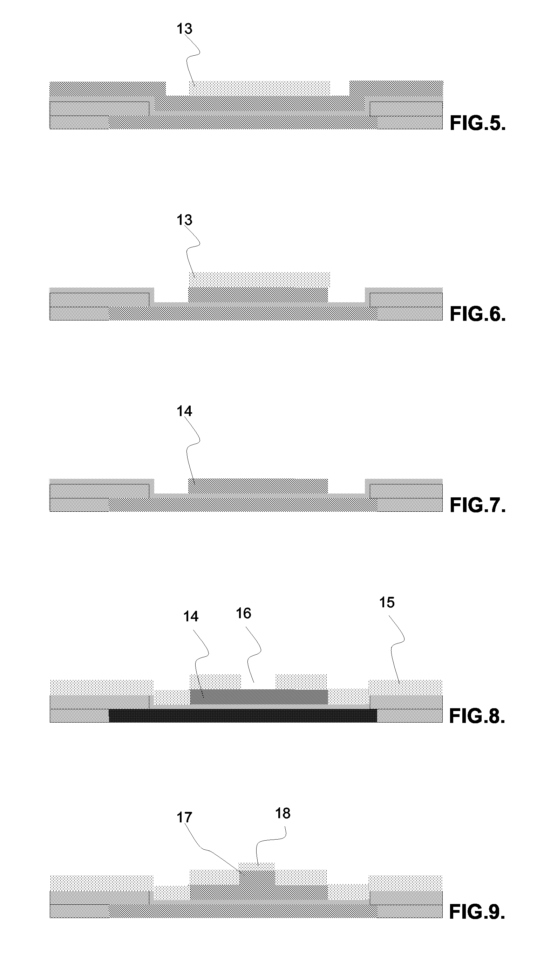

Pour des raisons de simplifications, les figures 4 à 18 ne représentent que la partie supérieure du composant, dans la zone où est réalisée la structure capacitive.

De façon générale, les dimensions des différentes couches et éléments réels peuvent différer de celles des couches et éléments qui sont représentés aux figures uniquement dans le but de faire comprendre l'invention.

### Manière de réaliser l'invention

Comme déjà évoqué, l'invention concerne un micro-composant incorporant un micro-condensateur réalisé selon une structure spécifique, particulièrement avantageuse en termes de capacitance, c'est-à-dire de capacité par unité de surface.

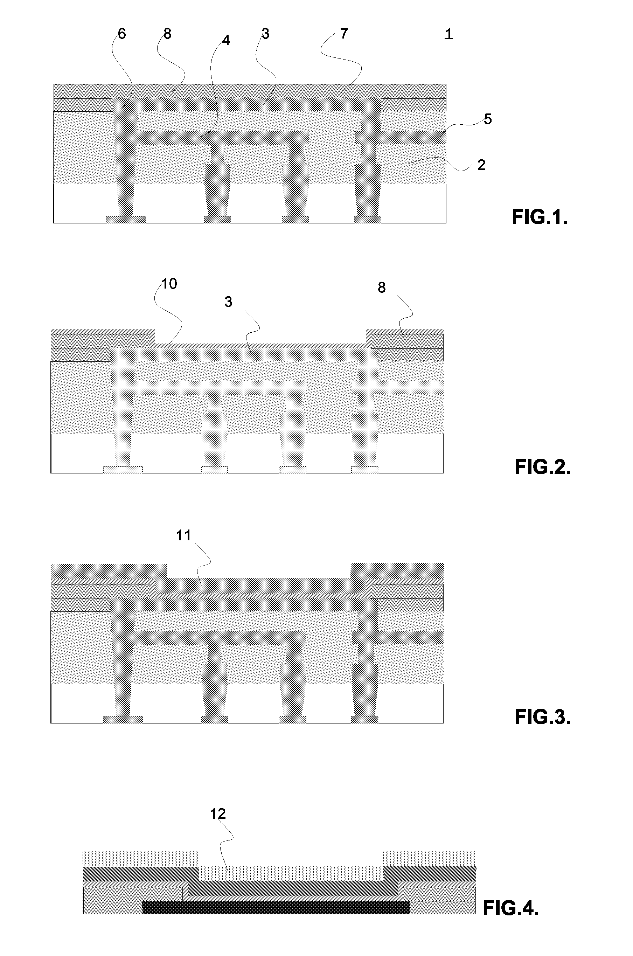

Un tel micro-condensateur peut être réalisé sur un micro-composant (1) tel qu'illustré à la figure 1. Pour illustrer la possibilité de réaliser le micro-condensateur à différents niveaux du micro-composant, le substrat (2) illustré à la figure 1 comprend plusieurs niveaux de métallisation (3, 4, 5). Le substrat (2) comporte également un plot d'interconnexion (6) débouchant sur la face supérieure (7) du substrat. Plus précisément, cette face supérieure (7) est recouverte d'une couche de passivation (8), typiquement en SiO₂ ou SiON. Néanmoins, l'invention ne se limite pas à cette seule forme de gamme de micro-composants présentant une structure interne à plusieurs niveaux de métallisation.

On décrit par la suite un procédé particulier de réalisation qui permet d'obtenir la structure de micro-capacités conforme à l'invention. Certaines étapes du procédé peuvent néanmoins être considérées comme accessoires ou simplement utiles et avantageuses pour améliorer certaines performances, sans être absolument obligatoires pour rester dans le cadre de l'invention.

Ainsi, dans une première étape illustrée à la figure 2, on procède à la gravure de la couche de passivation (8), de manière à laisser apparaître le niveau de métallisation (3) sous-jacent. La gravure de la couche de passivation (8) peut, lorsque cette dernière est réalisée en SiON, être effectuée par un procédé classique de gravure chimique utilisant un mélange CF₄:O₂ ou CF₄:H₂ ou bien encore une technique de type "Reactive Ion Etching" (RIE), voire encore en utilisant un plasma radiofréquence.

On procède par la suite à une étape de nettoyage permettant d'éliminer toute trace restante de SiON ou des produits utilisés pour sa gravure. Ce nettoyage peut par exemple être réalisé en utilisant une solution commercialisée sous la référence ACT 970 par la Société ASHLAND. Ce nettoyage peut être suivi d'un pré-rinçage avec dissolution de dioxyde de carbone ou d'ozone par bullage, avec un acide hydroxyle carboxylique tel que de l'acide citrique ou encore de l'acide oxalique.

Par la suite, on procède au dépôt de la couche barrière à diffusion de l'oxygène (10) tel qu'illustré à la figure 2. Cette couche barrière à la diffusion fera office de couche amorce pour le dépôt des couches supérieures. Cette couche sert également à améliorer la résistance à l'électro-migration et à la diffusion de l'oxygène. Cette couche peut être déposée par une technique de dépôt de couches atomiques également appelée ALD pour "Atomic Layer Déposition". Une telle technique confère une très bonne uniformité d'épaisseur et une excellente intégrité à cette couche barrière à diffusion (10). Les matériaux susceptibles d'être utilisés pour réaliser cette couche barrière à la diffusion peuvent être du nitrure de titane ou du nitrure de tungstène, du nitrure de tantale, ou encore un des matériaux suivants : TaA1N, TiA1N, MoN, CoW ou TaSiN.

Par la suite, et comme illustré à la figure 3, on procède au dépôt d'une couche conductrice destinée à former la lamelle inférieure de l'électrode centrale. Cette couche (11) peut être déposée par différentes techniques classiques, parmi ces techniques, on peut citer les techniques connues sous les abréviations PVD, E-BEAM, CVD, ALD, ainsi que les procédés de croissance électrolytique.

Les matériaux aptes à être employés pour former cette couche formant la base de l'électrode (11) peuvent être choisis dans le groupe comprenant : le tungstène, le molybdène, le ruthénium, l'aluminium, le titane, le nickel, le gallium, le palladium, le platine, l'or, l'argent, le niobium, l'iridium, le dioxyde de iridium, le dioxyde de ruthénium, l'yttrium, le dioxyde d'yttrium ainsi que le cuivre. L'épaisseur ainsi déposée est typiquement supérieure à 100 nanomètres.

Par la suite, on procède comme illustré aux figures 4 à 7 à différentes étapes de gravure permettant de délimiter dans le plan du substrat la position de l'électrode centrale de la micro-capacité. Ces différentes étapes se décomposent tout d'abord comme illustré à la figure 4 par le dépôt d'une couche de résine (12) recouvrant le dépôt métallique (11). Cette couche (12) est ensuite insolée puis éliminée dans les zones périphériques pour ne demeurer que dans la zone (13) située à l'aplomb de la première électrode, comme illustré à la figure 5.

On procède par la suite comme illustré à la figure 6 à la gravure de la couche métallique (11) en dehors de la zone protégée par la couche de résine (13). Cette dernière est ensuite éliminée comme illustrée à la figure 7 pour laisser apparaître la partie inférieure (14) qui formera la base de la première électrode. Par la suite, et comme illustré à la figure 8, on procède au dépôt d'une couche structurante (15) qui permettra par la suite de définir différents canaux dans lesquels seront effectués des dépôts métalliques qui permettront la construction de la première électrode. On choisira un matériau métallique susceptible d'être gravé en définissant des parois relativement planes et perpendiculaires au substrat. Parmi ces matériaux, on pourra choisir une résine photosensible, telle que notamment les résines commercialisées sous les références SJR 57-40 ou SU 8 par les sociétés SHIPLEY et CLARIANT.

On peut également utiliser un polyimide, et notamment ceux commercialisés par la société DUPONTt DE NEMOURS, ou du benzocyclobutène (BCB) photosensible fabriqué par la société DOW CHEMICAL. Il est également possible d'utiliser un matériau commercialisé sous la référence CYCLOTENE DRYETCH série 3 par la société DOW CHEMICAL. On peut également déposer une couche de SOG (SPIN ON GLASS), ou bien encore de polysilicium, ou bien encore de l'oxyde de silicium (SiO₂) ou de l'oxynitrure de silicium (SiON) qui peuvent être déposés par différentes techniques de dépôt chimique en phase vapeur PECVD (Plasma Enhanced Chemical Vapor Déposition), LPCVD (Low Pressure Chemical Vapor Déposition), ou APCVD (Atmosphère Pressure Chemical Vapor Déposition).

On procède par la suite et comme toujours illustré à la figure 8, à la définition d'une tranchée centrale (16) réalisée au niveau médian de la première lamelle métallique (14). Cette tranchée centrale est obtenue par lithographie et/ou gravure de manière à éliminer la couche structurante (15) jusqu'à laisser apparaître la couche (14) formant la partie basse de l'électrode.

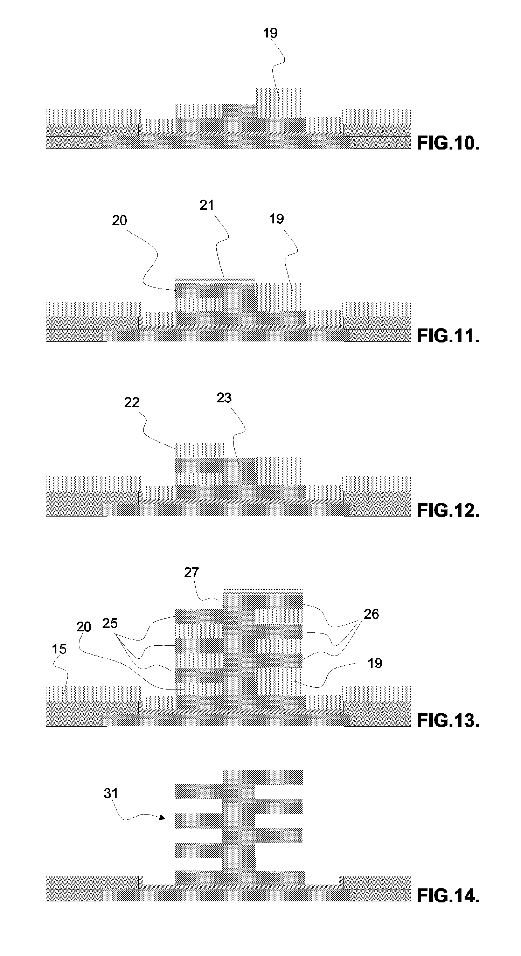

Par la suite, on procède comme illustré à la figure 9 à un dépôt métallique dans la tranchée (16), de manière à définir un plot (17) au-dessus de la base métallique (14). Ce plot (17) est ensuite protégé par le dépôt d'une résine photosensible (18). Par la suite, on procède à un nouveau dépôt d'une résine analogue à celle utilisée pour former la couche structurante (15). Cette nouvelle couche structurante est éliminée à l'exception de la zone (19), située d'un côté du plot métallique (17), comme illustré à la figure 10

Par la suite, on procède comme illustré à la figure 11 au dépôt d'une nouvelle couche métallique formant une lamelle (20) s'étendant depuis le plot central (17) jusqu'à un côté de la première électrode. Ce dépôt métallique est effectué selon une épaisseur sensiblement égale à celle de la couche structurante (19) déposée du côté opposé de l'électrode. La lamelle (20) illustrée à la figure 11 est obtenue après que le dépôt métallique ait subi une étape de gravure par une technique de "lift off". La lamelle métallique (20) ainsi obtenue est ensuite protégée par le dépôt d'une couche de résine photosensible (21) recouvrant sa face supérieure.

On procède ensuite comme illustré à la figure 12 à l'élimination de la couche de résine (21) puis au dépôt d'une couche structurante qui n'est conservée que dans la zone (22) située d'un côté de l'électrode, en dehors du tronc central (23). Par la suite, on procède en enchaînant les différentes étapes de dépôt métallique, puis de dépôt de couche structurante, de manière à obtenir la structure illustrée à la figure 13. L'électrode possède donc alors une structure arborescente formée des différentes lamelles (25, 26) s'étendant autour du tronc central (27). On obtient ainsi une superposition de différentes lamelles présentant chacune une épaisseur de l'ordre de 150 Angströms. Bien entendu, ces dimensions sont données à titre d'exemple, et peuvent être modifiées en fonction des valeurs des capacités ou de capacitance souhaitée.

Par la suite on procède, à l'élimination de la couche structurante (15) et des différentes portions de couches structurantes (19, 22) restant entre les lamelles (25, 26), pour obtenir la structure illustrée à la figure 14. Cette élimination a lieu en employant un solvant dédié à la formulation de la couche structurante.

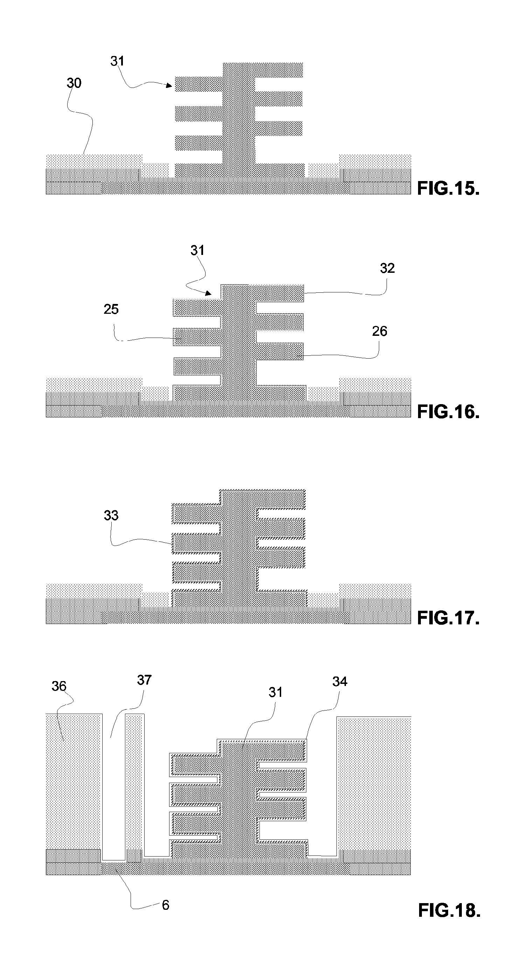

Par la suite, comme illustré à la figure 15, on procède au dépôt d'une nouvelle couche structurante (30) permettant de protéger la zone du micro-composant située en dehors de la première électrode vis à vis des futures diffusions ou dépôts ultérieurs.

On procède par la suite comme illustré à la figure 16 au dépôt d'une couche barrière (32) recouvrant l'intégralité de la surface extérieure de la première électrode (31), y compris dans les espaces définis entre les lamelles successives (25, 26).

On procède par la suite comme illustré à la figure 17, au dépôt d'une structure nano-laminée (33) réalisée à partir de différentes couches d'oxyde ferroélectrique et/ou pyroélectrique. Dans un exemple particulier de réalisation, la structure nanolaminée (33) peut comporter un empilement de huit couches différentes.
. La première couche, possédant une épaisseur de 5 à 10 Å est réalisée à partir de A1ₓO₃₋ₓ, avec x compris entre 0.et 3.
. La seconde couche présente une épaisseur de l'ordre de 10 à 15 Å, et est réalisée à partir de Ta_{z-2}O_{5-z}Al₂Oₓ ,avec z compris entre 0et 2.
. La troisième couche d'une épaisseur de l'ordre de 15 à 20 Å réalisée à partir de TiO₂ Al_{X} O_{3+y}, avec y compris entre 0et3.
. La quatrième couche d'une épaisseur de l'ordre de 40 à 100 Å est réalisée à partir de TiO_{y-x} Ta_{z-2}O_{5+z}.
. La cinquième couche, d'une épaisseur de 60 à 200 Å est réalisée à partir de TiO_{y}Ta_{3-z}O_{z}.
. Les sixième, septième et huitième couches sont identiques respectivement aux troisième, deuxième et première couches.

La structure nano-laminée ainsi obtenue présente une épaisseur comprise entre 200 et 400 Å . La permittivité relative de cette couche est de l'ordre de 23.

Bien entendu, la structure nano-laminée décrite ci-avant est un exemple non limitatif dans laquelle certains éléments peuvent être substitués sans sortir du cadre de l'invention.

Par la suite, comme illustré à la figure 18, on procède au dépôt d'une nouvelle couche structurante (36), qui est typiquement obtenue en BCB, en polyimide, en Parylène® ou en cyclotène®^{.}

Cette couche structurante (36) est gravée pour définir une tranchée (37) à l'aplomb du plot d'interconnexion (6) ainsi que dans la zone entourant l'électrode (31). L'ensemble de la couche structurante (36) et de l'électrode (31) reçoit le dépôt d'une couche barrière (34) à diffusion typiquement réalisée en nitrure de titane. Dans le cas où l'on souhaite réaliser la seconde électrode en cuivre électrolytique, on procède également au dépôt d'une couche amorce de cuivre. Cette couche amorce est ensuite recouverte sur les faces supérieures des portions de couches structurantes (36), de manière à empêcher la croissance ultérieure du cuivre électrolytique.

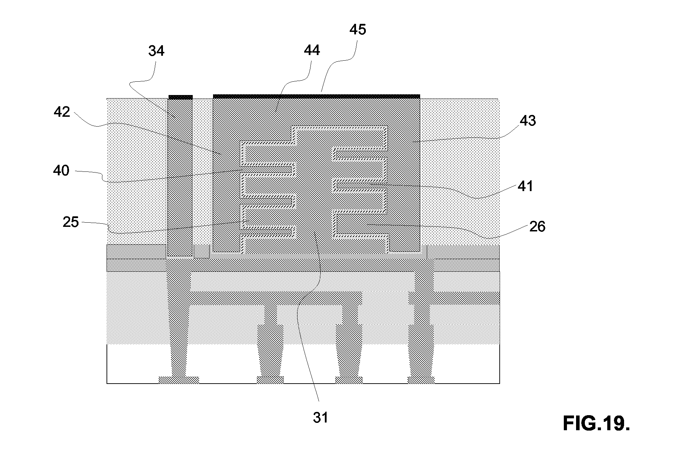

Par la suite, on procède comme illustré à la figure 19 au dépôt électrolytique de cuivre de manière à remplir la tranchée (37) reliée au point d'interconnexion (6), et à combler l'espace défini autour de la première électrode (31).

La portion (38) de cuivre déposée à l'aplomb d'interconnexion (6) permet de rendre accessible au niveau supérieur du composant le plot d'interconnexion (6) mais également le niveau de métallisation (3) auquel est reliée la première électrode (31).

Le dépôt de cuivre électrolytique permet également de former la seconde électrode remplissant les espaces situés entre les différentes lamelles (25, 26) de la première électrode. Ce dépôt définit donc des lamelles (40, 41) de part et d'autre de la première électrode. Certaines de ces lamelles (40) sont reliées à une paroi commune (42), les autres lamelles (41) étant reliées à une autre paroi commune (43).

Les parois communes (42, 43) sont elles-mêmes reliées au niveau supérieur par une portion transversale (44) formant également le plot de connexion de l'électrode supérieure (45). On peut procéder par la suite comme illustré à la figure 19, au dépôt d'une couche de passivation typiquement en chrome, ou en Nitrure de Tantale, Nitrure de Titane, Molybdène, recouvrant à la fois la portion (38) de liaison à la première électrode et la seconde électrode (45).

A titre d'exemple, on peut ainsi réaliser des micros-capacités ayant une capacitance supérieure à 25 nanoFarad par millimètre carré, en définissant des épaisseurs de lamelles de l'ordre du micromètre, chacune des lamelles possédant sensiblement une longueur de l'ordre de 5 micromètres, l'épaisseur du tronc central étant voisine de 2,5 micromètres. Il est possible d'empiler un nombre important de lamelles, typiquement un nombre supérieur à 10. Bien entendu, les chiffres donnés ne le sont qu'à titre d'exemple non limitatif, et l'invention couvre de nombreuses variantes de réalisation.

Il ressort de ce qui précède que les capacités conformes à l'invention peuvent être obtenues avec des valeurs de capacitance très élevées sans engendrer de coûts importants en ce qui concerne leur procédure de réalisation.

En outre, ces micro capacités possèdent l'avantage de pouvoir être utilisées pour des opérations ultérieures, réalisées directement sur le circuit intégré, puisque les deux électrodes de la capacité sont accessibles sur la face supérieure des micro-composants équipés du micro-condensateur.

## Revendications

1. Micro-composant électronique (1) réalisé à partir d'un substrat (2), et incorporant une structure capacitive réalisée au-dessus du dernier niveau de métallisation (3) apparent réalisé dans le substrat, ladite structure capacitive comportant deux électrodes (31,45), **caractérisé en ce qu'**une des électrodes (31) comporte un ensemble de lamelles (25,26) superposées et décalées de l'une à l'autre par rapport à un tronc central (27), l'autre électrode (45) comportant deux ensembles de lamelles (40,41), les lamelles (40,41) de chacun de ces ensembles étant intercalées entre les lamelles (25,26) de la première électrode (31) en étant reliées entre elles par une paroi commune (42,43), les deux parois commune (42,43) étant elles-mêmes reliées (44) par dessus la première électrode (31).

2. Micro-composant selon la revendication 1, **caractérisé en ce que** les électrodes (31,45) sont séparées par une couche diélectrique (33) réalisée à partir de matériaux choisis dans le groupe des oxydes ferro-électriques et/ou pyroélectriques.

3. Micro-composant selon la revendication 2, **caractérisé en ce que** la couche de matériaux diélectrique (33) est réalisée par une superposition de couches élémentaires de matériaux différents formant une structure nanolaminée.

4. Micro-composant selon la revendication 3, **caractérisé en ce que** la stoechiométrie des matériaux varie d'une couche élémentaire à l'autre de la structure nanolaminée (33).

5. Micro-composant selon la revendication 1, **caractérisé en ce que** la surface de chaque électrode (31,45) est recouverte d'une couche (32,34) d'un matériau barrière à la diffusion de l'oxygène.

6. Micro-composant selon la revendication 1, **caractérisé en ce que** pour chaque électrode (31,45), les différentes lamelles (25,26,40,41) sont réalisées à partir du même matériau.

7. Micro-composant selon la revendication 6, **caractérisé en ce que** les électrodes sont réalisées à partir de cuivre.

8. Procédé de fabrication d'une structure capacitive sur un micro-composant (1) réalisé à partir d'un substrat, ladite structure capacitive étant fabriquée au-dessus du dernier niveau de métallisation apparent (3) réalisé sur le substrat, **caractérisé en ce qu'**il comporte les étapes suivantes consistant à :
■ déposer au-dessus du niveau de métallisation (3), une couche métallique (11) destinée à former la partie basse (14) d'une des deux électrodes (31) de la structure capacitive ;
■ déposer au-dessus de la couche métallique (11) une couche structurante (12) de manière à définir un canal destiné à accueillir un dépôt métallique ;
■ déposer dans le canal ainsi formé un dépôt métallique (20);
■ renouveler les deux étapes précédentes en décalant une fois sur l'autre la position de la couche structurante pour ne couvrir qu'une partie de la couche métallique sous-jacente, de manière à également décaler la position des dépôts métalliques (25,26), et obtenir une structure arborescente formant la première électrode (31);
■ déposer au-dessus de la première électrode (31) une couche de matériau diélectrique (33);
■ déposer par dessus la première électrode (31) un matériau conducteur venant s'insérer entre les couches métalliques (25,26) de la première électrode, de manière à former la seconde électrode (45).
